# EUROPEAN PATENT APPLICATION

(11) **EP 2 141 963 A1**
(43) Date of publication of application: **06.01.2010**
(21) Application number: 08720456.6
(22) Date of filing: 13.03.2008
(51) Int. Cl.: H05B 33/04, G09F 9/00, G09F 9/30, H01L 27/32, H01L 51/50, H05B 33/02, H05B 33/10

(54) **ORGANIC EL PANEL AND METHOD FOR MANUFACTURING THE SAME**

(30) Priority: 29.03.2007 JP 2007088520
(71) Applicant: Fujifilm Corporation, Tokyo 106-8620 (JP)
(72) Inventor: WARASHINA, Hidenaga, Ashigarakami-gun Kanagawa 258-8577 (JP); SHIMOTSU, Shinichi, Ashigarakami-gun Kanagawa 258-8577 (JP); SONODA, Shinichiro, Ashigarakami-gun Kanagawa 258-8577 (JP); GOTO, Chiaki, Ashigarakami-gun Kanagawa 258-8577 (JP); MIURA, Takehito, Tokyo 106-8620 (JP)
(74) Representative: Klunker . Schmitt-Nilson . Hirsch
(86) International application number: PCT/JP2008/000570
(87) International publication number: WO 2008/120453

(57) **Abstract**

[PROBLEMS] To suppress organic EL panel deterioration due to water or the like of an organic EL element to minimum.

[MEANS FOR SOLVING PROBLEMS] An organic EL element (12) is provided by sandwiching an organic material layer (3), including a light emitting functional layer, between a pair of electrodes (2, 4) formed on the element forming substrate (1). An organic EL panel is provided by bonding the element forming substrate (1) and a sealing substrate (1'), through an adhesive layer (8) arranged at the periphery of the element forming substrate (1) to surround the organic EL element (12). In the organic EL panel, a hermetically sealing section adjacent to the adhesive layer (8) and composed of low melting point metal layers (6, 6') is arranged.

## Description

### BACKGROUND OF THE INVENTION

### Field of the Invention

This invention relates to an organic EL panel, which comprises an organic EL element sealed between substrates, and a method for manufacturing the organic EL panel.

### Description of the Related Art

Display panels utilized for various kinds of electronic equipment and domestic electric equipment, such as portable telephones, computers, electronic pocketbooks, and portable game machines, are ordinarily manufactured by sealing the display sections of the display panels for protecting the display sections. Particularly, currently used organic EL elements have the problems in that, in cases where the organic EL elements are affected by water, oxygen, or the like, peeling from electrodes occurs, the elements themselves suffer from deterioration, and light emission service lifes of the elements become short.

Therefore, there have heretofore been proposed various techniques for blocking and sealing the display panels from water, oxygen, or the like (the ambient atmosphere containing water, oxygen, or the like). For example, in a patent literature 1, a technique is described, wherein an organic EL element on an element forming substrate is covered by a silicon monoxide protective film, and wherein the region between the element forming substrate and a sealing substrate is entirely sealed with a resin. Also, in a patent literature 2, a technique is described, wherein a resin layer intervenes between an element forming substrate and a sealing substrate so as to cover an organic EL element, and where the periphery of the resin layer is sealed with an adhesive.

Each of the sealing methods described in the patent literatures 1 and 2 is provided with the structure, wherein the resin covers the entire area of the organic EL element and join the element forming substrate and the sealing substrate to each other. The sealing substrate may be constituted of a thin flat plate, such as glass, and it is not necessary to use a metal vessel, which is provided with a recess, or glass having been subjected to etching processing. Therefore, each of the sealing methods described in the patent literatures 1 and 2 is advantageous in that the organic EL panel, which is thin in thickness and light in weight, is manufactured at a low cost.

However, with the sealing method described in the patent literature 1, the resin intervening between the element forming substrate and the sealing substrate has the characteristics permeable to water. Also, since the resin is in contact with air at the exterior, water at the exterior permeates through the resin and comes up to the silicon monoxide protective film (inorganic film) . Besides silicon monoxide, the inorganic film formed on the organic EL element is apt to have structural defects, such as pinholes. Therefore, the problems occur in that water goes beyond the protective film, comes up to the organic EL element, and causes the characteristics of the organic EL element to deteriorate. Also, with the structure, wherein the inorganic film is formed on the organic EL element and is covered by the resin layer, breakage of the element and cracking of the inorganic film are apt to occur due to stress. Therefore, the thickness of the inorganic film is naturally limited, and it is substantially impossible to perform perfectly hermetic sealing.

With the sealing method described in the patent literature 2, wherein the additional sealing section formed by the adhesive is present at the periphery of the resin layer, the resin layer is not in direct contact with the ambient atmosphere. However, since the adhesive has the characteristics permeable to water, the problems occur in that water contained in the ambient atmosphere permeates successively through the adhesive and the resin layer, comes up to the organic EL element, and causes the characteristics of the organic EL element to deteriorate.

Specifically, each of the sealing methods described in the aforesaid patent literatures 1 and 2 has the effects of prolonging the period of time occurring before the deterioration of the organic EL element begins and consequently prolonging the service life of the organic EL element. However, the problems with regard to the permeation of water contained in the ambient atmosphere and with regard to water coming up to the organic EL element are not eliminated essentially. Also, ordinarily, the water permeation rate through the adhesive layer and the resin layer increases in accordance with the temperature rise. Therefore, each of the sealing techniques described above will not always be satisfactory with respect to reliability of the organic EL panel used in, particularly, a high-temperature environment.

In a patent literature 3, a sealing structure is described, wherein a periphery of a sealing substrate, which has a depressed center section, and a periphery of an element forming substrate are joined together through a low melting point metal layer. In contrast to the resin layer and the adhesive layer described in the aforesaid patent literatures 1 and 2, the low melting point metal layer is not permeable to water vapor and is therefore advantageous in that the deterioration of the organic EL element due to water permeating from the exterior is prevented.
Patent literature 1: Japanese Patent No. 3354444
Patent literature 2: Japanese Unexamined Patent Publication No. 2005-190703
Patent literature 3: Japanese Unexamined Patent Publication No. 2004-265837

However, the sealing method described in the aforesaid patent literature 3 has several problems described below. Specifically, firstly, since the sealing substrate has the depressed area at the center section, the thickness of the sealing substrate itself becomes large, and the thickness of the organic EL panel becomes larger than the cases where a flat sealing substrate is used. This constitutes a serious problem in the cases of the display panel which should have the advantages of the thin film.

Secondly, since the organic EL panel has the structure, in which the organic EL element is exposed to the hollow section of the organic EL panel, if certain fine defects arise at the sealing section constituted of the low melting point metal layer, and if a small quantity of water vapor or oxygen flows through the fine defects into the hollow section of the organic EL panel, the characteristics of the organic EL element will deteriorate instantaneously and destructively. Thirdly, since the cost of the sealing glass substrate provided with the depressed area is higher than the cost of a flat glass plate, the problems occur in that it is not always possible to use the organic EL panel in practice.

As described above, heretofore, there have not been proposed an organic EL panel which satisfies all of the requirements with regard to the sealing effect, the structural problems, and economy, and a method for manufacturing the organic EL panel which satisfies the requirements described above.

### SUMMARY OF THE INVENTION

In view of the above circumstances, the primary object of the present invention is to provide an organic EL panel, wherein deterioration of an organic EL element due to water, or the like, is suppressed to the minimum, and wherein service life of the organic EL element is prolonged markedly.

Another object of the present invention is to provide a method for manufacturing the organic EL panel.

The present invention provides an organic EL panel, comprising:
i) an element forming substrate,
ii) an organic EL element, which is formed on the element forming substrate,
iii) an adhesive layer, which is formed at a periphery of the element forming substrate so as to surround the organic EL element, and
iv) a sealing substrate, which is bonded to the element forming substrate through the adhesive layer,
   wherein a hermetically sealing section, which is provided with low melting point metal layers, is formed at a position adjacent to the adhesive layer.

The organic EL panel in accordance with the present invention should preferably be modified such that a light absorbing layer is formed at a position between the low melting point metal layers and the sealing substrate and/or at a position between the low melting point metal layers and the element forming substrate.

The organic EL panel in accordance with the present invention should more preferably be modified such that the organic EL element is covered by a resin layer, and the resin layer is in contact with the sealing substrate.

Also, the organic EL panel in accordance with the present invention should preferably be modified such that the organic EL element comprises a pair of electrodes and an organic material layer, which includes a light emitting functional layer and which is sandwiched between the pair of the electrodes.

The present invention also provides a method for manufacturing an organic EL panel, comprising the steps of:
i) forming an organic EL element on an element forming substrate,
ii) forming an adhesive layer at a periphery of the element forming substrate so as to surround the organic EL element, and
iii) bonding a sealing substrate and the element forming substrate to each other through the adhesive layer,
   wherein low melting point metal layers are formed at a position adjacent to the adhesive layer, whereby the organic EL element is sealed.

The method for manufacturing an organic EL panel in accordance with the present invention should preferably be modified such that a light absorbing layer is formed at a position between the lowmelting point metal layers and the sealing substrate and/or at a position between the low melting point metal layers and the element forming substrate, and a laser beam is irradiated from the side provided with the light absorbing layer toward the low melting point metal layers. In such cases, the laser beam should preferably have wavelengths falling within the range of 300nm to 600nm.

The organic EL panel in accordance with the present invention comprises: (i) the element forming substrate, (ii) the organic EL element, which is formed on the element forming substrate, (iii) the adhesive layer, which is formed at the periphery of the element forming substrate so as to surround the organic EL element, and (iv) the sealing substrate, which is bonded to the element forming substrate through the adhesive layer, wherein the hermetically sealing section, which is provided with the low melting point metal layers, is formed at the position adjacent to the adhesive layer. Therefore, the deterioration of the organic EL element due to water, or the like, is suppressed to the minimum, and the service life of the organic EL element is prolonged markedly.

Also, with the organic EL panel in accordance with the present invention, the adhesive layer is formed at the position adjacent to the hermetically sealing section, which is provided with the low melting point metal layers. Therefore, in cases where fine defects arise at the hermetically sealing section, which is provided with the low melting point metal layers, by virtue of the adhesive layer, the adverse effects of the fine defects do not occur directly upon the organic EL element. Accordingly, destructive deterioration of the characteristics of the organic EL panel is suppressed.

The method for manufacturing an organic EL panel in accordance with the present invention comprises the steps of: (i) forming the organic EL element on the element forming substrate, (ii) forming the adhesive layer at the periphery of the element forming substrate so as to surround the organic EL element, and (iii) bonding the sealing substrate and the element forming substrate to each other through the adhesive layer, wherein the low melting point metal layers are formed at the position adjacent to the adhesive layer, whereby the organic EL element is sealed. Therefore, the organic EL panel, wherein the deterioration of the organic EL element due to water, or the like, is suppressed to the minimum, and wherein the service life of the organic EL element is prolonged markedly, is manufactured economically and practically.

Particularly, the method for manufacturing an organic EL panel in accordance with the present invention should preferably be modified such that the light absorbing layer is formed at the position between the low melting point metal layers and the sealing substrate and/or at the position between the low melting point metal layers and the element forming substrate, and the laser beam is irradiated from the side provided with the light absorbing layer toward the low melting point metal layers. With the modification described above, the organic EL panel is manufactured such that the deterioration of the resin substrate does not occur during the manufacturing processes, and such that the adverse effects, such as the deterioration of the organic EL element, are suppressed to the minimum.

### BRIEF DESCRIPTION OF THE DRAWINGS

Figure 1 is a schematic sectional view showing an embodiment of the organic EL panel in accordance with the present invention,
Figure 2 is an enlarged fragmentary sectional view showing the organic EL panel of Figure 1,
Figure 3A is an explanatory view showing one of processes for manufacturing the organic EL panel in accordance with the present invention,
Figure 3B is an explanatory view showing one of the processes for manufacturing the organic EL panel in accordance with the present invention,
Figure 3C is an explanatory view showing one of the processes for manufacturing the organic EL panel in accordance with the present invention,
Figure 3D is an explanatory view showing one of the processes for manufacturing the organic EL panel in accordance with the present invention,
Figure 3E is an explanatory view showing one of the processes for manufacturing the organic EL panel in accordance with the present invention,
Figure 3F is an explanatory view showing one of the processes for manufacturing the organic EL panel in accordance with the present invention,
Figure 3G is an explanatory view showing one of the processes for manufacturing the organic EL panel in accordance with the present invention,
Figure 3H is an explanatory view showing one of the processes for manufacturing the organic EL panel in accordance with the present invention,
Figure 4 is a schematic perspective view showing an irradiation apparatus used for manufacture of the organic EL panel in accordance with the present invention,
Figure 5 is a graph showing absorption spectrums of glass, Au, and Cu,
Figure 6 is a schematic sectional view showing a different embodiment of the organic EL panel in accordance with the present invention,
Figure 7 is a schematic sectional view showing a further different embodiment of the organic EL panel in accordance with the present invention, and
Figure 8 is a schematic sectional view showing a still further different embodiment of the organic EL panel in accordance with the present invention.

### DESCRIPTION OF THE PREFERRED EMBODIMENTS

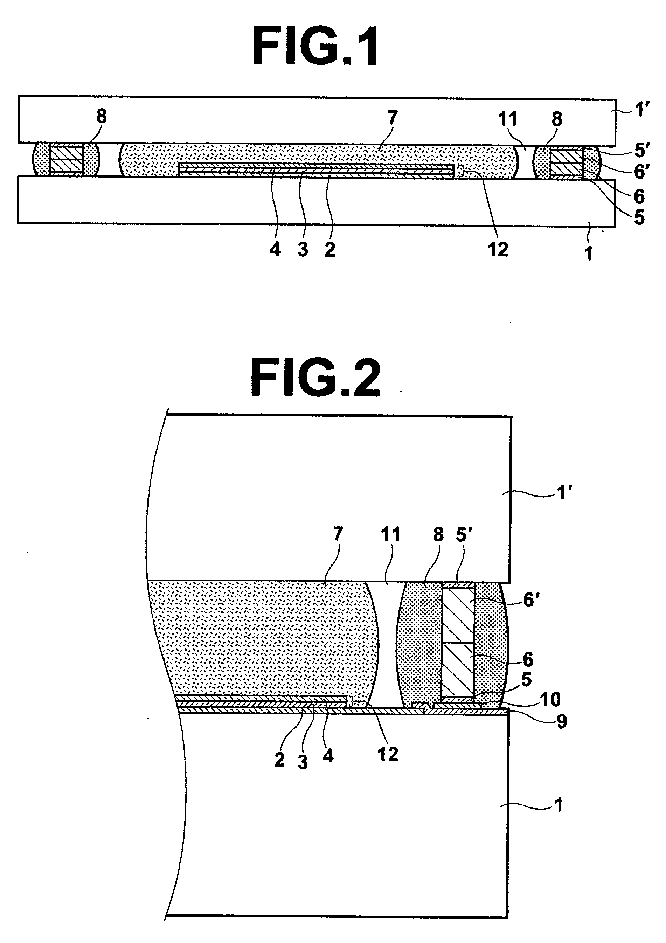

The present invention will hereinbelow be described in further detail with reference to the accompanying drawings. Figure 1 is a schematic sectional view showing an embodiment of the organic EL panel in accordance with the present invention. Figure 2 is an enlarged fragmentary sectional view showing the organic EL panel of Figure 1.

As illustrated in Figure 1, the embodiment of the organic EL panel in accordance with the present invention comprises a transparent electrode 2, an organic layer 3, and a top electrode 4, which are formed in this order on an element forming substrate 1. The transparent electrode 2, the organic layer 3, and the top electrode 4 together constitute an organic EL element 12. An entire area of the organic EL element 12 is covered by a resin layer 7. A sealing substrate 1' is formed on the resin layer 7. In this embodiment, as each of the element forming substrate 1 and the sealing substrate 1', a glass substrate having a thickness of 0. 7mm is used. Also, as the transparent electrode 2, an ITO electrode having a thickness of 100nm is used. Further, as the organic layer 3, a composite layer, which comprises a positive hole transporting layer, a light emitting layer, and an electron transporting layer overlaid in this order, is used. Furthermore, as the top electrode 4, a composite layer, which comprises a lithium fluoride layer and an aluminum layer overlaid in this order, is used.

The resin layer 7 covers the entire area of the organic EL element 12 and fills a center section of the space between the element forming substrate 1 and the sealing substrate 1'. As the resin layer 7, it is possible to use a photo-setting type adhesive, an acrylic resin, an epoxy resin, a polyester, a polyolefin, a high-molecular elastomer, or the like. In this embodiment, the epoxy resin is used as the resin layer 7.

The element forming substrate 1 and the sealing substrate 1' are hermetically sealed at the peripheries thereof by low melting point metal layers 6 and 6'. The low melting point metal layer 6 is bonded through a light absorbing layer 5 to the element forming substrate 1. Also, the low melting point metal layer 6' is bonded through a light absorbing layer 5' to the sealing substrate 1'. The hermetically sealing section formed in the manner described above is covered on the opposite sides thereof by an adhesive layer 8, which is adjacent to the low melting point metal layers 6 and 6'.

As the adhesive layer 8, it is possible to use a photo-setting type adhesive, an acrylic resin, an epoxy resin, a polyester, a polyolefin, or the like. In this embodiment, the photo-setting type adhesive is used as the adhesive layer 8. The resin layer 7 and the adhesive layer 8 maybe constituted of two different kinds of resins. Alternatively, the resin layer 7 and the adhesive layer 8 may be constituted of an identical type of a resin.

Each of the light absorbing layers 5 and 5' may be constituted of a material having good adhesion properties with respect to the element forming substrate 1 and the low melting point metal layer 6 or with respect to the sealing substrate 1' and the low melting point metal layer 6', and having an absorptivity with respect to the wavelength range of the laser beam irradiated for fusing the low melting point metal layers 6 and 6' in the later stage, which absorptivity is sufficiently higher than the absorptivity of the element forming substrate 1 and the sealing substrate 1'. For example, each of the light absorbing layers 5 and 5' should preferably be constituted of Cu, Au, or the like. In cases where gold or copper is used as each of the light absorbing layers 5 and 5', for example, chromium may be used as a primary layer material for enhancing the adhesion with respect to the element forming substrate 1 and the sealing substrate 1'.

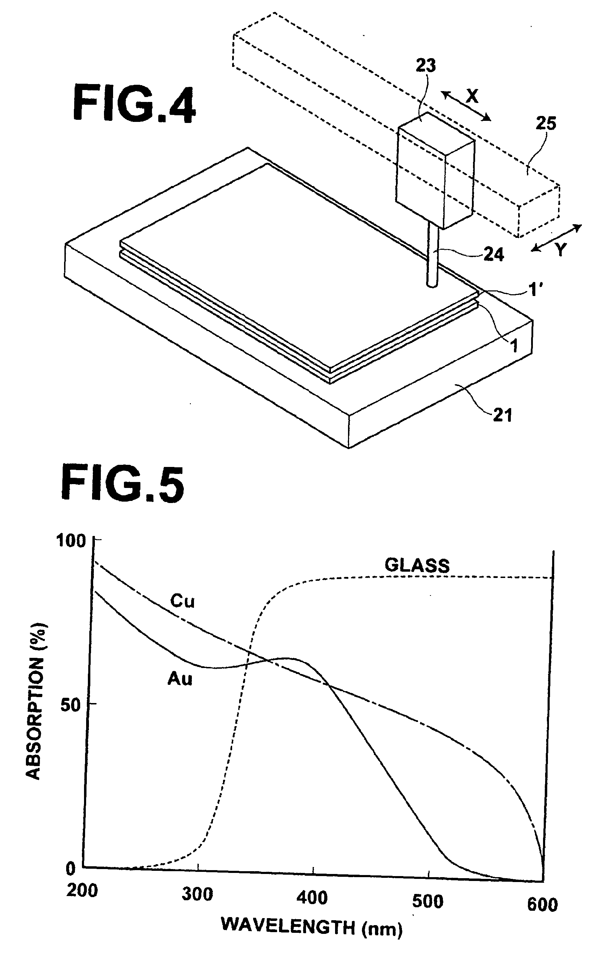

Figure 5 shows absorption spectrums of glass, which is taken as an example of the material for the element forming substrate 1 and the sealing substrate 1', and gold and copper, which are taken as examples of the materials for the light absorbing layers 5 and 5'. For example, gold is appropriate in cases where a laser beam having wavelengths falling within the range of 300nm to 500nm is selected as the laser beam. Also, copper is appropriate in cases where a laser beam having wavelengths falling within the range of 300nm to 600nm is selected as the laser beam. Further, in cases where glass is used as the substrate, and in cases where the absorption spectrum of glass is taken into consideration, the wavelength of the laser beam should preferably be equal to at least 300nm. Each of the light absorbing layers 5 and 5' may have a thickness sufficient for the laser beam to be absorbed. In this embodiment, each of the light absorbing layers 5 and 5' is constituted of a chromium primary layer having a width of 300µm and a thickness of 20nm and a gold layer having a width of 300µm and a thickness of 200nm.

In cases where the irradiation of the laser beam is performed only from the side of the sealing substrate 1', at the time of the selection of the material for the light absorbing layer 5 on the side of the element forming substrate 1, only the adhesion properties with respect to the element forming substrate 1 and the low melting point metal layer 6 may be taken into consideration. Also, in such cases, the light absorbing layer may be formed only at the position between the element forming substrate 1' and the low melting point metal layer 6', i.e., only the light absorbing layer 5' may be formed.

Each of the low melting point metal layers 6 and 6' is the layer constituted of a metal (or an alloy) having a low melting point (a melting point of at most 250°C). Each of the low melting point metal layers 6 and 6' may be constituted of the simple substance of the low melting point metal, such as indium or tin, or an alloy containing the low melting point metal, which has the melting point equal to at least the operating temperature of the organic EL panel and lower than the melting point of the element forming substrate 1 and the sealing substrate 1'. In this embodiment, each of the low melting point metal layers 6 and 6' is constituted of indium.

The resin layer 7 and the adhesive layer 8 may be in contact with each other. Alternatively, as illustrated in Figure 1 and Figure 2, a space 11 may intervene between the resin layer 7 and the adhesive layer 8. However, the space 11 should preferably be filled with an inert gas, such as dry nitrogen. Ordinarily, in cases where the peripheral sealing section is not formed, the thickness of the resin layer 7 may fall within the range of 5µm to 30µm. In the cases of the structure in accordance with the present invention, the thickness of the resin layer 7 may fall within the range described above, but is not limited to the range described above. The sum of the thickness of the low melting point metal layer 6 and the thickness of the low melting point metal layer 6' is approximately equal to the thickness of the resin layer 7.

The thickness of the low melting point metal layer 6 and the thickness of the low melting point metal layer 6' may be identical with each other. However, for example, in cases where the irradiation of the laser beam is performed only from the side of the sealing substrate 1', the thickness of the low melting point metal layer 6' may be set to be markedly smaller than the thickness of the low melting point metal layer 6. In such cases, the joint surface of the low melting point metal layer 6 and the low melting point metal layer 6' may be located at the position in the vicinity of the light absorbing layer 5', which is heated by the laser beam. Therefore, the intensity of the laser beam necessary for the fusion bonding is kept low, the processing time is kept short, and the temperature rise around the fusion bonded section is suppressed. In this embodiment, the width of each of the low melting point metal layer 6 and the low melting point metal layer 6' is set to be equal to the width of each of the light absorbing layers 5 and 5'. Also, the thickness of the low melting point metal layer 6' is set to be equal to 5µm, and the thickness of the low melting point metal layer 6 is set to be equal to 15µm. In cases where the thickness of the low melting point metal layer 6 and the thickness of the low melting point metal layer 6' are thus different from each other, the sum of the thickness of the low melting point metal layer 6 and the thickness of the low melting point metal layer 6' is set to be equal to the desired thickness of the resin layer 7.

Though not shown in Figure 1, in order for the organic EL element to be actuated, lead-out electrodes respectively connected electrically to the transparent electrode 2 or the top electrode 4 are formed so as to extend across the peripheral sealing section, and application of electric power from the exterior is performed. The structure of the section described above will hereinbelow be described with reference to Figure 2. At least one pair of lead-out electrodes 9 is formed on an area of the element forming substrate 1. Each of the lead-out electrodes 9 is electrically connected to the transparent electrode 2 or the top electrode 4, which have been formed on the element forming substrate 1. An insulating film 10 having the electrical insulating characteristics is formed at the region of each of the lead-out electrodes 9, which region corresponds to the peripheral sealing section, such that the plurality of the lead-out electrodes 9 may not be short-circuited by the light absorbing layer 5 and the low melting point metal layer 6, which are formed on the insulating film 10. In this embodiment, a chromium material having a thickness of 50nm is used as the lead-out electrodes 8, and an SiO₂ film having a thickness of 50nm is used as the insulating film 10.

Each of the low melting point metal layer 6 and the light absorbing layer 5 has the substantially uniform thickness over the entire area of the periphery of the element forming substrate 1. Therefore, the region, at which each of the lead-out electrodes 9 is formed, becomes higher than the region, at which each of the lead-out electrodes 9 is not formed, by the sum of the thickness of each of the lead-out electrodes 9 and the thickness of the insulating film 10. However, each of the lead-out electrodes 9 may have a thickness sufficient for the supply of the electric power to the organic EL element. Also, the insulating film 10 may have a thickness necessary for keeping the electrical insulating characteristics with respect to the voltage applied between the lead-out electrodes 9 which are adjacent to each other. Further, the voltage applied between the lead-out electrodes 9 which are adjacent to each other is typically at most approximately 20V, and therefore the insulating film 10 may have a markedly small thickness. Accordingly, the sum of the thickness of each of the lead-out electrodes 9 and the thickness of the insulating film 10 is capable of being restricted to approximately 100nm. Also, the thickness of the low melting point metal layer 6 may fall within the range of 1µm to 20µm and may typically be equal to approximately 10µm. Therefore, the increase of the height from the element forming substrate 1 to the top surface of the low melting point metal layer 6, which increase arises due to the insertion of each of the lead-out electrodes 9 and the insulating film 10, is approximately 1%. Accordingly, no obstruction occurs at the time at which the low melting point metal layer 6 on the side of the element forming substrate 1 and the low melting point metal layer 6' on the side of the sealing substrate 1' are fused and joined to each other.

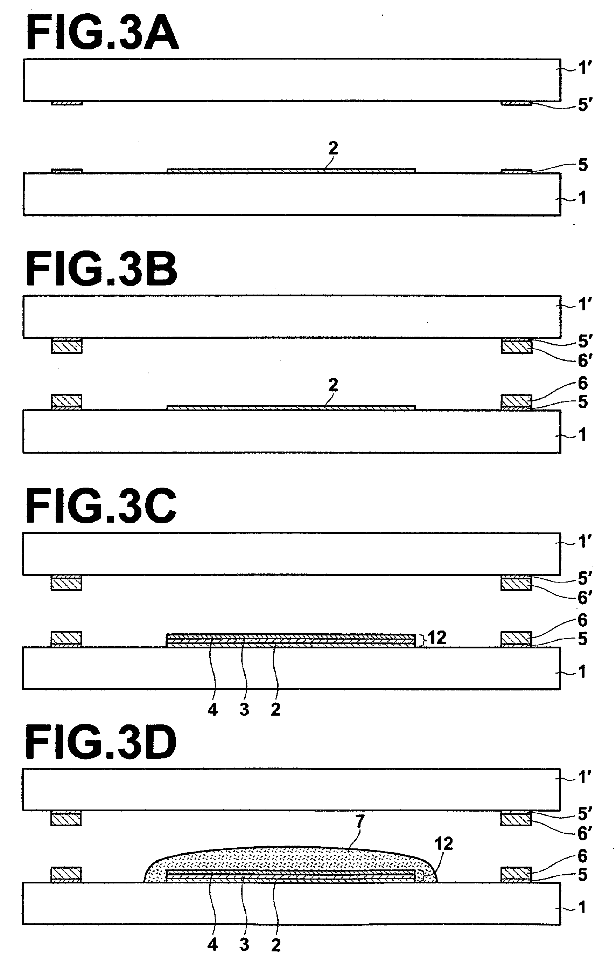

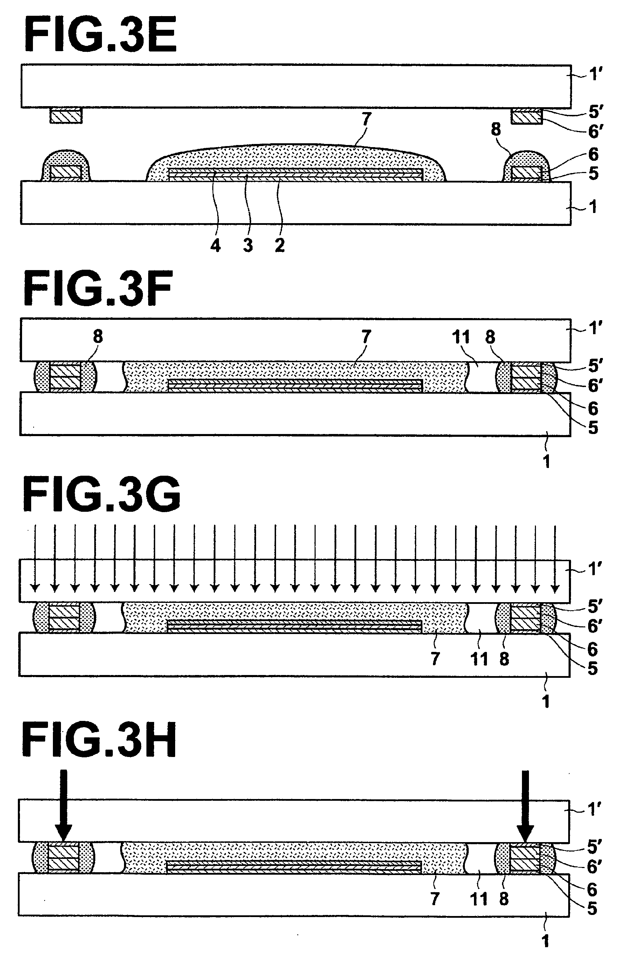

How the organic EL panel in accordance with the present invention is manufactured will be described hereinbelow with reference to Figure 3. Firstly, as shown in Figure 3A, the transparent electrode 2, the lead-out electrode (not shown), and the insulating film (not shown) are formed on the element forming substrate 1, which is transparent. Thereafter, the light absorbing layer 5 is formed at the periphery of the element forming substrate 1, and the light absorbing layer 5' is formed at the periphery of the sealing substrate 1'. Each of the light absorbing layers 5 and 5' is formed by use of a metal mask and with a vacuum evaporation technique.

Thereafter, as shown in Figure 3B, the low melting point metal layers 6 and 6' are formed respectively on the light absorbing layers 5 and 5' by use of a metal mask and with the vacuum evaporation technique as in the cases of the light absorbing layers 5 and 5'.

The technique for forming each of the transparent electrode 2, the lead-out electrode, the insulating film, the light absorbing layers 5 and 5', and the low melting point metal layers 6 and 6' may be selected in accordance with the material and from the vacuum evaporation technique, a sputtering technique, a chemical vapor phase growth technique, and the like. As for pattering of each of the layers described above, the film formation may be performed in the state in which the metal mask, or the like, is located close to the underside layer. Alternatively, after the layer has been formed, etching processing may be performed for the patterning.

As shown in Figure 3C, for forming the organic EL element 12 on the element forming substrate 1, the organic layer 3 is formed on the transparent electrode 2. Ordinarily, the organic layer 3 is constituted of a plurality of layers. Each of the layers may be formed with a spin coating technique, the vacuum evaporation technique, an ink-jet printing technique, a screen printing technique, a gravure printing technique, or the like. Thereafter, the top electrode 4 is formed with the vacuum evaporation technique. The top electrode 4 is electrically connected to the lead-out electrodes (not shown).

Thereafter, as shown in Figure 3D, the resin layer 7 is formed so as to cover the entire area of the organic EL element 12 and so as to fill the center section of the space between the element forming substrate 1 and the sealing substrate 1'. The resin should preferably be applied such that the resin height is largest in the vicinity of the center section of the element and decreases little by little as the position becomes spaced away from the center point. A dispenser maybe used for this process. Alternatively, one of other coating techniques may be used. This process should preferably be performed in an inert gas atmosphere, such as dry nitrogen. In this embodiment, the process is performed in a dry nitrogen atmosphere, in which an oxygen concentration is at most 10ppm, and in which a dew point is at most -70°C.

After the dispensing of the resin layer 7, as shown in Figure 3E, the adhesive 8 is coated on the low melting point metal layer 6. This process may be performed with an apparatus ordinarily used for the coating of a sealing adhesive. The process for coating the adhesive 8 may be performed before the dispensing of the resin layer 7.

As shown in Figure 3F, the sealing substrate 1' is bonded onto the resin layer 7 and the adhesive layer 8, which are in the unhardened state. At this time, the majorities of the surfaces of the low melting point metal layers 6 and 6' are in contact with each other. It often occurs that a part of the adhesive of the adhesive layer 8 remains in a thin film form or a droplet form at the joint surface. In cases where the pressure applied on the element forming substrate 1 and the sealing substrate 1' is adjusted appropriately at the time of the bonding of the two substrates together, the majority of the residual adhesive is capable of being discharged from the joint surface of the low melting point metal layers 6 and 6'. However, even though a small quantity of the residual adhesive is present, adverse effects do not markedly occur on the sealing performance with the low melting point metal layers 6 and 6'.

It often occurs that the space 11 remains at the region between the two substrates, which region is surrounded by the peripheral sealing section. Therefore, this process should preferably be performed in an inert gas atmosphere, such as dry nitrogen. At this time, the resin layer 7 should preferably cover at least the actually operating region of the organic layer 3 and the region of the top electrode 4 just on the actually operating region of the organic layer 3. However, particularly, connecting sections of the transparent electrode 2 and the top electrode 4, which connecting sections are connected to the lead-out electrodes, and redundant sections of the transparent electrode 2 and the top electrode 4 need not necessarily be covered by the resin layer 7.

In cases where the resin layer 7 is constituted of the photo-setting type adhesive, as shown in Figure 3G, light having wavelengths necessary for the hardening of the resin layer 7 and the adhesive layer 8 and having necessary energy is irradiated through the sealing substrate 1' to the resin layer 7 and the adhesive layer 8. In this manner, the resin layer 7 and the adhesive layer 8 are hardened. In this embodiment, the light produced by a mercury vapor lamp is irradiated. The irradiation may be performed simultaneously with respect to the resin layer 7 and the adhesive layer 8. Alternatively, the irradiation may be performed successively with respect to the resin layer 7 and the adhesive layer 8.

Ordinarily, in cases where the photo-setting type adhesive hardens, the volume thereof decreases. The surfaces of the low melting point metal layers 6 and 6' having been covered by the adhesive layer 8 are in contact with each other before the hardening of the adhesive layer 8 is performed. Due to contraction of the adhesive layer 8, attracting force arises between the sealing substrates 1 and 1'. Therefore, the surfaces of the low melting point metal layers 6 and 6' are pushed against each other by the contraction force.

Thereafter, as shown in Figure 3H, the laser beam is irradiated through the sealing substrate 1' to the light absorbing layer 5'. The light absorbing layer 5' is heated by the irradiation of the laser beam, and the low melting point metal layers 6 and 6' are fused and fusion bonded together by the heat of the light absorbing layer 5'. The fusion bonding of the low melting point metal layers may be performed before the hardening of the resin layer 7 and the adhesive layer 8. Alternatively, the hardening of the resin layer 7 and the adhesive layer 8 and the fusion bonding of the low melting point metal layers may be performed simultaneously. Also, the irradiation of the laser beam for the fusion bonding may be performed from the side of the element forming substrate 1. As another alternative, the irradiation of the laser beam for the fusion bonding may be performed simultaneously from the sides of the two substrates.

In order for the laser beam to be irradiated from the side of the sealing substrate 1' so as to scan the light absorbing layer 5' at the periphery, for example, an irradiation apparatus as illustrated in Figure 4 may be used. The irradiation apparatus illustrated in Figure 4 comprises a support base 21 for supporting the sealing substrates 1 and 1', between which the organic EL element, the low melting point metal layers, and the light absorbing layers intervene. The irradiation apparatus also comprises a laser head 23 for radiating out a GaN type diode laser beam 24 having wavelengths falling within the range of 400nm to 410nm. The irradiation apparatus further comprises an X-Y movement mechanism 25 for moving the laser head 23 in parallel with the support base 21 so as to irradiate the laser beam to the light absorbing layer. The X-Y movement mechanism 25 supports the laser head 23 and is capable of moving in the X-axis direction and the Y-axis direction in parallel above the support base 21. The laser beam radiated out from the laser head 23 is irradiated through the side of the sealing substrate 1' so as to trace the peripheral sealing section. In this embodiment, the output of the laser head 23 is set at 1W, and a parallel beam having a diameter of 400µm is irradiated at a scanning speed of 2mm/s.

As described above, the processes up to the hardening of the resin layer 7 and the adhesive layer 8 are capable of being performed by use of the sealing apparatus, which has heretofore been available commercially. Therefore, it is rational that the process for hardening the resin layer 7 and the adhesive layer 8 is performed previously and that the fusion bonding of the low melting point metal layers is thereafter performed in the state in which the resin layer 7 and the adhesive layer 8 have hardened and in which the stable form has been obtained. In lieu of the heating with the irradiation of the laser beam being performed, the hermetic characteristics are obtained to a certain extent by pressure joining with the contraction force of the adhesive layer 8. Therefore, for simplification of the processes, the process for the fusion bonding with the laser beam may be omitted.

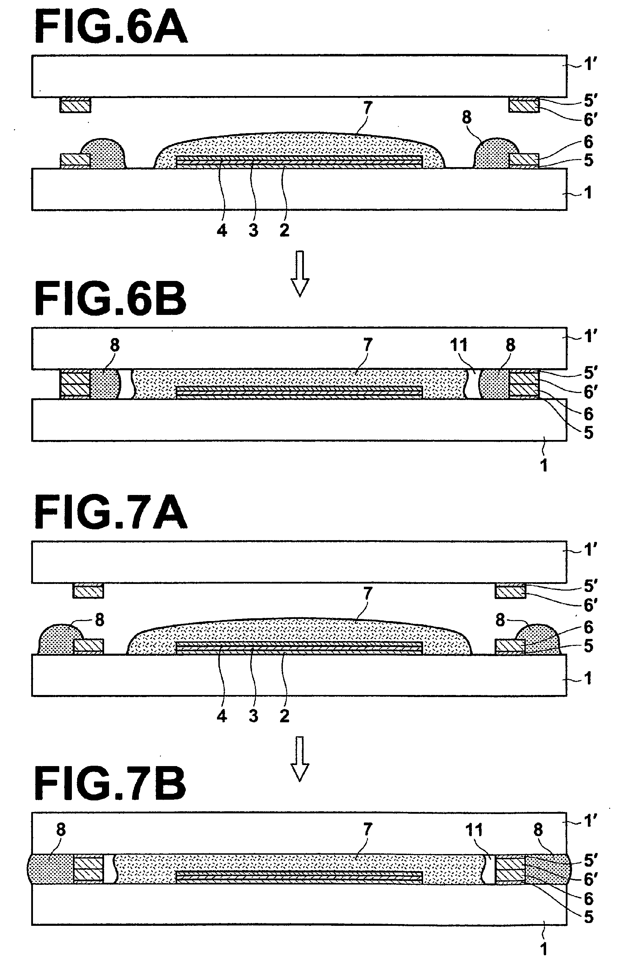

Figure 6 shows a different embodiment, in which the position of the coating of the adhesive layer is altered. The embodiment shown in Figure 6 is approximately identical with the embodiment shown in Figure 1 to Figure 3, except that, as shown in Figure 6A, the position of the coating of the adhesive layer 8 is shifted intendedly toward the side of the organic EL element. As a result, as shown in Figure 6B, little material for the adhesive layer is sandwiched between the low melting point metal layers 6 and 6', the low melting point metal layers 6 and 6' are directly joined together, and more reliable hermetical sealing is obtained.

Conversely, as shown in Figure 7, the position of the adhesive layer 8 may be shifted to the side outward from the low melting point metal layers 6 and 6'. In each of the cases described above, for the processes for the coating and the hardening of the adhesive layer 8, the manufacturing facilities available heretofore are capable of being utilized. Also, the effect of the pressure joining of the surfaces of the low melting point metal layers 6 and 6' by the contraction of the adhesive layer 8 is obtained as in the embodiments described above.

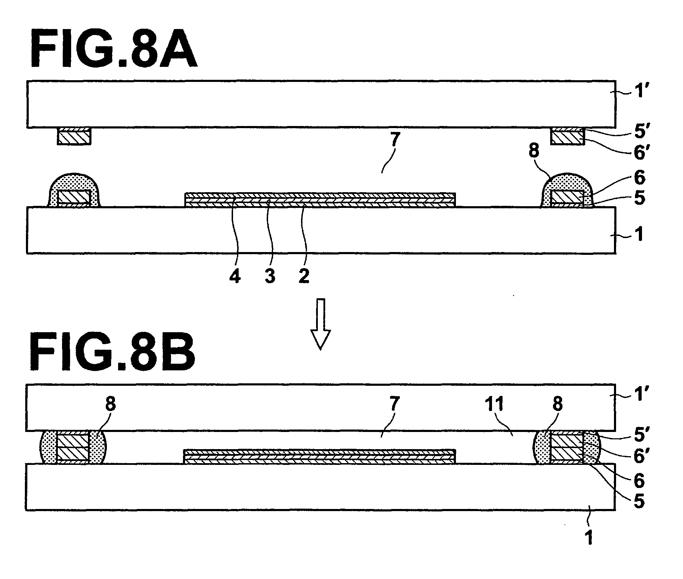

An embodiment, in which the resin layer 7 is not provided, is illustrated in Figure 8. The embodiment shown in Figure 8 is approximately identical with the embodiment shown in Figure 1 to Figure 3, except that the resin layer 7 which covers the entire area of the element is not provided, and an inert gas, such as dry nitrogen, is sealed in the space 11. In cases where the structure shown is employed, the mechanical strength and the hermetic characteristics are obtained by virtue of the adhesive layer 8, which is formed at the periphery, and the inorganic sealing structure, which includes the low melting point metal layers 6 and 6'.

## Claims

1. An organic EL panel, comprising:
i) an element forming substrate,
ii) an organic EL element, which is formed on the element forming substrate,
iii) an adhesive layer, which is formed at a periphery of the element forming substrate so as to surround the organic EL element, and
iv) a sealing substrate, which is bonded to the element forming substrate through the adhesive layer,
wherein a hermetically sealing section, which is provided with low melting point metal layers, is formed at a position adjacent to the adhesive layer.

2. An organic EL panel as defined in Claim 1 wherein a light absorbing layer is formed at a position between the low melting point metal layers and the sealing substrate and/or at a position between the low melting point metal layers and the element forming substrate.

3. An organic EL panel as defined in Claim 1 or 2 wherein the organic EL element is covered by a resin layer, and the resin layer is in contact with the sealing substrate.

4. An organic EL panel as defined in Claim 1, 2, or 3 wherein the organic EL element comprises a pair of electrodes and an organic material layer, which includes a light emitting functional layer and which is sandwiched between the pair of the electrodes.

5. A method for manufacturing an organic EL panel, comprising the steps of:
i) forming an organic EL element on an element forming substrate,
ii) forming an adhesive layer at a periphery of the element forming substrate so as to surround the organic EL element, and
iii) bonding a sealing substrate and the element forming substrate to each other through the adhesive layer,
wherein low melting point metal layers are formed at a position adjacent to the adhesive layer, whereby the organic EL element is sealed.

6. A method for manufacturing an organic EL panel as defined in Claim 5 wherein a light absorbing layer is formed at a position between the low melting point metal layers and the sealing substrate and/or at a position between the low melting point metal layers and the element forming substrate, and a laser beam is irradiated from the side provided with the light absorbing layer toward the low melting point metal layers.

7. A method for manufacturing an organic EL panel as defined in Claim 6 wherein the laser beam has wavelengths falling within the range of 300nm to 600nm.
